Europäisches Patentamt

European Patent Office

Office européen des brevets

(11) Numéro de publication : **0 011 021**
**B1**

(12) **FASCICULE DE BREVET EUROPÉEN**

(45) Date de publication du fascicule du brevet :
24.02.82

(21) Numéro de dépôt : 79400784.9

(22) Date de dépôt : 23.10.79

(51) Int. Cl.³ : **H 01 L 31/12, H 01 L 31/10,
H 01 L 33/00**

(54) **Procédé de réalisation de composants semiconducteurs présentant des propriétés de conversion optoélectroniques.**

(30) Priorité : 26.10.78 FR 7830497

(43) Date de publication de la demande :
14.05.80 (Bulletin 80/10)

(45) Mention de la délivrance du brevet :
24.02.82 Bulletin 82/08

(84) Etats contractants désignés :
**BE DE GB IT NL**

(56) Documents cités :
**US - A - 3 366 819**
**US - A - 3 413 506**

(73) Titulaire : **COMMISSARIAT A L'ENERGIE ATOMIQUE
Etablissement de Caractère Scientifique Technique
et Industriel
B.P. 510
F-75752 Paris Cedex 15 (FR)**

(72) Inventeur : **Bensahel, Daniel
12, Boulevard Maréchal Leclerc
F-38000 Grenoble (FR)**
Inventeur : **Pfister, Jean-Claude
24, Lotissement Eden Montbonnot
F-38330 Saint Ismier (FR)**
Inventeur : **Revoil, Louis
22, rue Sisteron
F-38170 Seyssinet Pariset (FR)**

(74) Mandataire : **Mongrédien, André et al
c/o Brevatome 25, rue de Ponthieu
F-75008 Paris (FR)**

Imprimerie Jouve, 18, rue St-Denis, 75001 Paris, France

Procédé de réalisation de composants semiconducteurs présentant des propriétés de conversion optoélectroniques

La présente invention a pour objet un procédé de réalisation de composants semiconducteurs présentant des propriétés de conversion optoélectroniques, c'est-à-dire des propriétés émettrices de lumière, réceptrices de lumière et éventuellement ces deux propriétés à la fois.

De façon plus précise, la présente invention concerne un procédé de fabrication de tels composants semiconducteurs qui peuvent émettre de la lumière dont la longueur d'onde est bien définie, et/ou à l'inverse, être le siège d'un courant lorsque ces composants sont soumis à un rayonnement lumineux.

Plus précisément encore, ces composants sont obtenus à partir du matériau semiconducteur ZnTe qui est de type P.

Un autre objet de l'invention est un procédé de réalisation de composants semiconducteurs émetteurs et/ou récepteurs de lumière, dans lesquels la tension de commande en direct pour l'émission de lumière est relativement faible.

Un autre objet de l'invention est un procédé de réalisation d'un tel composant semiconducteur qui ne nécessite pas d'opérations d'implantation ionique.

On a déjà expliqué, dans la demande de brevet n° EN 78/08522 déposée le 28 mars 1978 au nom du C.E.A. pour « Procédé de réalisation de diodes électroluminescentes et photodétectrices », les problèmes qui se posaient lorsque l'on veut réaliser, par des techniques classiques, une diode présentant, à la fois, des propriétés émettrices de lumière et détectrices de rayonnements lumineux. On a en particulier montré que les caractéristiques du composant, pour obtenir un bon rendement à l'émission et à la réception, étaient contradictoires dans le cadre des procédés classiques de réalisation. On se reportera avantageusement à ce texte pour en comprendre mieux les raisons.

Il est déjà connu de réaliser des diodes électroluminescentes et photodétectrices à partir du matériau ZnTe. Un tel procédé est, en particulier, décrit dans la demande de brevet français citée ci-dessus. Cependant, ce procédé nécessite une opération d'implantation ionique et compte tenu de sa structure, une tension de commande en direct relativement élevée est nécessaire pour la faire fonctionner.

Par ailleurs, on connaît des procédés de réalisation de diodes électroluminescentes à partir du matériau ZnTe, mais ces diodes présentent des caractéristiques différentes de celles qui font l'objet de la présente invention.

On peut citer l'article de : Crowder (Appl. Physics Letters 8, 148, 1966), le rendement est de 2 % dans le vert mais à 77 °K ; ou l'article (J. Appl. Physics 44, 10, octobre 1973) : les diodes qui sont décrites dans cet article ont été fabriquées à partir d'une structure MIS ; elles sont vertes à 77 °K, mais jaunes à la température ambiante.

On peut aussi citer les brevet américains n° 3 366 819 et 3 413 506 décrivant des composants uniquement électroluminescents réalisés à partir d'un cristal de ZnTe de type P. Comme précédemment, le fonctionnement de ces dispositifs nécessite une tension de commande en direct élevée ; puisque dans ces dispositifs, la luminescence résulte d'un phénomène d'avalanche.

Selon le procédé, objet de l'invention, on part d'une plaquette en matériau semiconducteur ZnTe brut de fabrication qui est donc de type P. On soumet la surface supérieure de ladite plaquette à une première diffusion d'une impureté donatrice créant une zone compensée à résistivité élevée, à une deuxième diffusion superficielle d'une impureté acceptrice et au dépôt de contacts métalliques sur les deux faces de ladite plaquette, la combinaison des deux diffusions effectuées simultanément créant une zone de piégeage de trous, de type P.

Cette double diffusion a un double rôle. D'une part, la diffusion de l'impureté donatrice a pour effet de créer une compensation du matériau semiconducteur de départ ZnTe en créant une zone de résistivité relativement élevée sur une profondeur relativement importante $x_j$. La double diffusion de l'impureté acceptrice et de l'impureté donatrice a pour rôle de réaliser une couche superficielle permettant l'injection, des électrons d'épaisseur $x_i \ll x_j$. Ce sont ces électrons qui en se recombinant avec les trous donneront la lumière de longueur d'onde bien définie. Dans la zone d'injection des électrons, on obtient deux autres propriétés importantes pour le fonctionnement du dispositif semiconducteur, à savoir élever le nombre de centres accepteurs et avoir une bonne efficacité de recombinaison sur un centre dû à cette impureté.

De préférence, l'impureté donatrice est de l'aluminium. Cette impureté donatrice peut être également l'indium, l'oxyde d'indium. L'impureté acceptrice est, de préférence, du lithium, mais elle peut également être du sodium ou du potassium.

Selon un mode de mise en œuvre, la double diffusion est réalisée en milieu oxydant.

La réalisation du milieu oxydant est obtenue de préférence en utilisant des sels ou des bases de métaux alcalins servant d'impuretés acceptrices et ayant des propriétés oxydantes. On peut citer : $LiNO_3$, $LiCO_3$, $LiCOOH$, $NaNO_3$, $NaCO_3$, $KNO_3$, $KCO_3$, $KOH$,...

Le milieu oxydant peut également être réalisé à l'aide d'un milieu gazeux entourant la plaquette semiconductrice lors de l'opération de double diffusion.

De toute façon, l'invention sera mieux comprise à la lecture de la description qui suit d'un mode de réalisation du dispositif semiconducteur objet de l'invention. La description se réfère aux figures annexées sur lesquelles on a représenté :

— sur la figure 1, une vue en coupe verticale d'une plaquette en ZnTe illustrant les étapes du procédé,

— sur les figures 2a et 2b, des courbes illustrant le fonctionnement des dispositifs obtenus par la mise en œuvre du procédé selon la fig. 1, et

— sur la figure 3 une vue en coupe verticale d'un autre mode de mise en œuvre du procédé objet de l'invention.

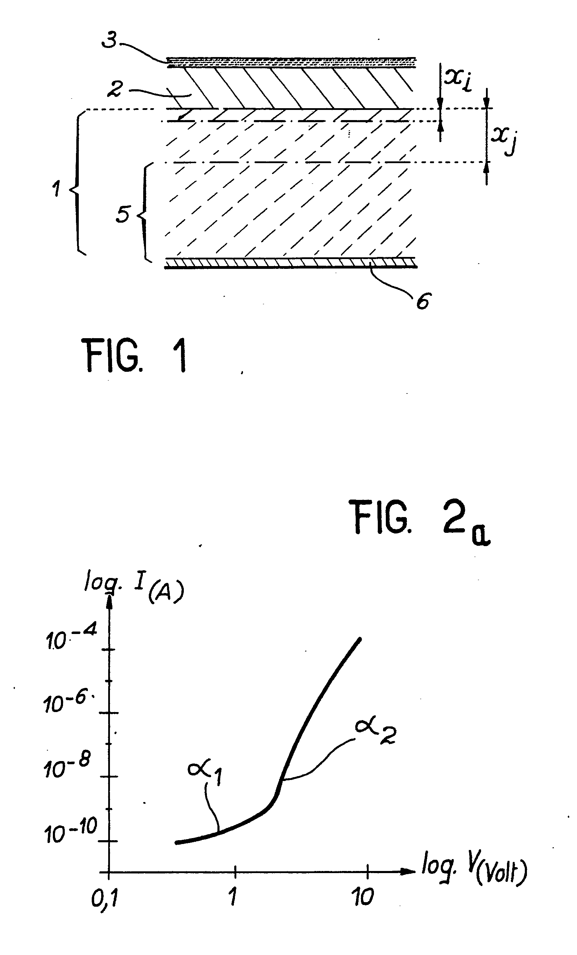

En se référant à la figure 1 annexée, on va décrire un exemple particulier de mise en œuvre du procédé, objet de l'invention, dans le cas où la double diffusion est réalisée en milieu oxydant. On part d'une plaquette 1 en ZnTe ayant une conductivité de type P. On dépose sur sa face supérieure une couche métallique 2 qui est réalisée dans cet exemple particulier en aluminium. Cette couche 2 est gravée de façon à délimiter les électrodes supérieures des composants élémentaires que doit comporter la plaquette. On réalise avant ou après gravure sur cette couche 2 un dépôt 3 de nitrate de lithium. Pour cela, on dépose sur l'aluminium 2 une solution de LiNO$_3$, H$_2$O (par exemple 0,01 mole de LiNO$_3$) ou LiNO$_3$, H$_2$O$_2$ (à 20 volumes). On laisse l'eau, ou l'eau oxygénée s'évaporer. Il reste quelques cristaux de LiNO$_3$ à la surface de l'aluminium. Lors du chauffage de la plaquette ainsi revêtue de ces deux couches supérieures (par exemple dans un four où circule un gaz inerte, N$_2$ ou N$_2$ légèrement hydrogéné) il se produit deux phénomènes de diffusion. D'une part, la couche en aluminium diffuse dans la plaquette en ZnTe sur une profondeur x$_j$ réalisant ainsi une zone compensée, c'est-à-dire une zone à résistivité élevée. Cette compensation résulte d'un processus propre ZnTe vis-à-vis de métaux tels que l'aluminium ; ZnTe, lorsqu'il est dopé, voit sa résistivité augmenter de plusieurs décades grâce à l'association des défauts présents dans le cristal brut de croissance avec l'aluminium introduit. L'autre rôle de cette diffusion est d'améliorer la qualité du contact entre la plaquette de ZnTe et la couche métallique 2 réalisée dans cet exemple particulier en aluminium.

L'impureté qui diffuse lors du chauffage à travers la couche métallique 2 provenant de la couche 3 pénètre dans la plaquette 1, ce qui se traduit par un accepteur dans la zone P du ZnTe. Cette zone devient encore plus conductrice qu'au départ grâce à l'afflux de centres accepteurs. Un autre rôle de cette diffusion est de créer dans la bande interdite du matériau ZnTe un niveau qui déterminera la longueur d'onde de recombinaison des électrons avec les trous, ces électrons venant, soit de la bande de conduction, soit d'un niveau proche de celle-ci.

Le rôle de la diffusion simultanée est de créer une couche superficielle qui permet l'injection des électrons. Cette couche de profondeur x$_i$(x$_i$<<x$_j$) superficielle permet le fonctionnement du dispositif.

La présence d'un oxydant dans la source d'impuretés favorise en même temps la formation d'une mince couche intermédiaire isolante qui forme une structure MIS favorable à l'injection d'électrons, ce qui améliore le rendement quantique de la diode.

On dépose ensuite l'électrode inférieure 6 (par exemple en Au) sur la face arrière de la plaquette.

Le fonctionnement en émetteur et en récepteur du dispositif ainsi obtenu est le suivant.

En polarisation directe de ce dispositif, il y a émission de lumière selon le mécanisme suivant : tant que la tension de base du dispositif est inférieure à un certain seuil, le courant qui circule dans la jonction est très faible car il est limité par la zone de charge d'espace existant dans la zone isolante ou zone compensée. Ce courant est composé essentiellement de trous venant de la partie du substrat 1 qui est resté de type P et remontant vers le contact métallique supérieur constitué par la couche 2. Sur leur passage, les trous sont piégés par la zone de piégeage ou d'injection d'épaisseur x$_i$. En conséquence, la densité de charge d'espace ρ dans cette zone de piégeage devient de plus en plus positive au fur et à mesure que l'on augmente la polarisation. Comme le champ électrique dans cette zone est directement lié à la valeur de ρ par l'équation :

$$E = \int \frac{Q}{\varepsilon} \cdot d\, x$$

(ε étant la constante diélectrique du semiconducteur)

il arrive un moment où pour une charge ρ$_c$, le champ électrique à l'interface métal-zone de piégeage d'épaisseur x$_i$ atteint une valeur critique E$_c$ à partir de laquelle les électrons peuvent être injectés par effet tunnel du contact supérieur vers la partie 5 du substrat 1 restée de type P. Ces électrons sont entraînés par le champ électrique qui règne dans la zone isolante d'épaisseur x$_j$ et vont se recombiner radiativement dans le substrat 5. La lumière ainsi engendrée sort du cristal par la face avant à travers le contact métallique supérieur 2.

Lorsque le dispositif n'est pas polarisé ou est polarisé en inverse, il règne près de la surface dans la zone de piégeage d'épaisseur x$_i$ et dans la zone isolante d'épaisseur x$_j$ un champ électrique. En tombant sur la face avant la lumière est absorbée sur une très faible profondeur de l'ordre de 0,1 micron. En conséquence, les paires électrons-trous sont créées directement dans la zone où règne un champ électrique intense.

Elles sont tout de suite soumises à l'effet du champ électrique et séparées. Ainsi, un courant photoélectrique circule dans le circuit extérieur du dispositif. L'efficacité de détection d'un tel dispositif est très grande car les électrons et les trous ont une faible probabilité de combinaison du fait de la présence du champ électrique dans l'épaisseur où ils sont créés.

Il faut remarquer que, grâce à la compensation préalable d'une partie du matériau semiconducteur ZnTe par la diffusion d'atomes de la couche métallique supérieure 2, on obtient une zone isolante x$_j$ de très haute résistivité. Cette résistivité élevée a pour effet d'améliorer très sensiblement les performances de ce dispositif. En effet, plus cette zone isolante est résistive, plus le courant de trous est limité, donc plus l'efficacité d'injection en émission de lumière est élevée. En effet, ce sont les électrons injectés à partir du contact vers le substrat en ZnTe qui produisent la luminescence alors que les trous ne participent pas à cette luminescence. En outre, le champ électrique sera efficace pour collecter les porteurs engendrés par la lumière incidente lors du fonctionnement du dispositif en détection.

Les courbes 2a et 2b illustrent le fonctionnement de tels dispositifs. La courbe 2a donne le courant I en fonction de la tension V, $I = V^\alpha$ (avec $\alpha_1 \simeq 1,5$ et $\alpha_2 \simeq 15 \pm 3$). La courbe 2b donne la puissance lumineuse émise (recueillie par exemple sur un photomultiplicateur) $V_L$ en fonction du courant I, $V_L = I^{\alpha'}$ (avec $\alpha' \simeq 2$).

Dans ce qui précède, on a décrit un mode préféré de mise en œuvre du procédé par dépôt d'une couche d'aluminium surmontée d'une couche de nitrate de lithium, ces deux couches servant à réaliser la double diffusion. Cependant, d'autres modes opératoires permettent de mettre en œuvre le procédé objet de l'invention.

Tout d'abord, on peut utiliser d'autres composés (sels ou bases d'alcalins) pour réaliser l'équivalent de la couche 3. A titre d'exemple, on peut utiliser $LiCO_3$, $LiCOOH$, $NaNO_3$, $NaCO_3$, $KNO_3$, $KCO_3$, $KOH$, ..., ces corps étant présents soit sous forme gazeuse, dans l'environnement de la plaquette conductrice, soit sous forme liquide lors du chauffage du dépôt métallique.

De même, pour réaliser la couche 2 de métallisation, on peut utiliser d'autres corps que l'aluminium pourvu que ces corps provoquent une compensation du matériau ZnTe après une simple diffusion. On peut citer par exemple l'indium et l'oxyde d'indium.

Comme on l'a déjà indiqué la double diffusion peut être réalisée dans un milieu qui n'est pas oxydant. Il peut être neutre ou même légèrement réducteur.

De même, au lieu de déposer deux couches distinctes, correspondant aux impuretés acceptrices et donatrices, on peut réaliser dans certains cas un alliage de ces deux matériaux et déposer ainsi une seule couche.

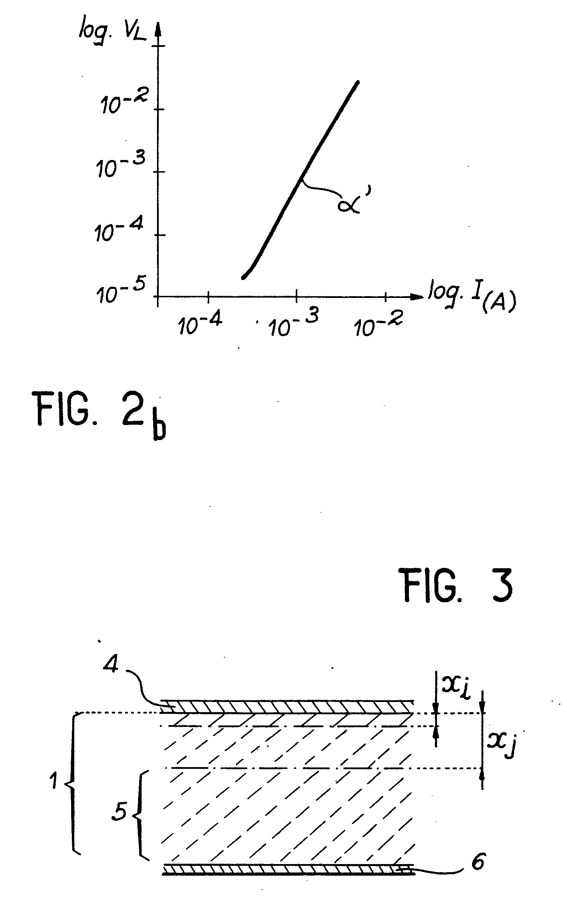

On va décrire ci-après un exemple de mise en œuvre correspondant au dépôt d'une seule couche et à une double diffusion en milieu neutre, en se référant à la figure 3.

Dans un premier temps, on réalise un alliage aluminium-lithium à 10 % de lithium. Cet alliage est réalisé de façon classique sous vide ou sous atmosphère réductrice.

Sur le substrat 1 en ZnTe, on dépose une couche 4 de cet alliage par évaporation sous vide. De préférence, cette couche 4 a une épaisseur de 1 micron. Cette épaisseur pourrait varier entre 0,5 et 3 microns.

L'ensemble est chauffé à 500 °C sous atmosphère neutre pour provoquer la double diffusion des éléments que contient la couche 4. D'une façon plus générale, cette opération peut être effectuée à une température comprise entre 450 °C et 600 °C. Après la double diffusion qui donne les mêmes zones de dopage que celles de la fig. 1, on réalise le branchement des électrodes.

Il faut également souligner que ce dispositif fonctionne du fait de sa structure, par injection d'électrons. En conséquence, la tension de commande est réduite.

En outre, il faut indiquer que le fonctionnement et l'émission de lumière verte sont pratiquement indépendants de la température à laquelle on fait fonctionner le dispositif.

Si l'on compare l'invention objet de la présente demande de brevet au procédé décrit dans la demande de brevet n° 78 08522 du 28 mars 1978, on peut relever les éléments suivants. La zone permettant l'injection d'épaisseur $x_i$ est de largeur plus faible que celle qui est créée par l'implantation ionique de la demande de brevet citée ci-dessus. En conséquence, la tension de commande est moins élevée. En outre, le procédé, objet de la présente invention, ne nécessite aucune opération d'implantation ionique et on ne rencontre donc pas dans le matériau semiconducteur de départ ZnTe les défauts qui peuvent être créés par une implantation ionique, même si la plus grande partie de ces défauts se trouve en fait localisée dans la couche métallique supérieure à travers laquelle on effectue l'implantation.

Par ailleurs, les applications des dispositifs semiconducteurs obtenus par la mise en œuvre du procédé, objet de l'invention, sont nombreuses.

Les dispositifs, objet de l'invention, qui sont à la fois électroluminescents et photodétecteurs présentent de nombreuses applications du fait que, de surcroît, un grand nombre de tels dispositifs élémentaires peuvent être réalisés sur un même substrat. On peut citer la réalisation d'un écran de visualisation et de lecteur de données, cet écran composé par une matrice de dispositifs discrets et adressables individuellement est capable de visualiser un ensemble d'informations d'une façon similaire à un écran cathodique et simultanément il joue le rôle d'un tube de prises d'images si on le met en mode de détection. Pour ces deux modes de fonctionnement, il est nécessaire d'adjoindre un circuit électronique de décodage.

On peut citer également la réalisation d'un système d'écriture et de lecture de documents. En projetant l'image de chaque dispositif discret sur un papier photosensible, il est possible de reconstituer sur un support utilisable (le papier) un signal électrique codé. De même, en projetant sur chaque dispositif discret l'image d'un document à lire, on pourrait avoir un signal électrique proportionnel à la quantité de lumière reçue par chaque point (signal vidéo). Dans cette perspective, les dispositifs semiconducteurs, objet de l'invention, peuvent servir d'organes de lecture et d'écriture dans les systèmes de transmission de données à distance tels que pour la télécopie, la téléinformatique, etc...

## Revendications

1. Procédé de réalisation d'un composant semiconducteur présentant des propriétés de conversion opto-électronique selon lequel la surface supérieure d'une plaquette (1) en matériau semiconducteur ZnTe de type P est soumise à une première diffusion d'une impureté donatrice créant une zone compensée à résistivité élevée $(x_j)$, à une deuxième diffusion superficielle $(x_i)$ d'une impureté acceptrice et au dépôt de contacts métalliques sur les deux faces, caractérisé en ce que la combinaison des deux diffusions effectuées simultanément crée une zone de piégeage de trous.

2. Procédé selon la revendication 1, caractérisé en ce que l'impureté donatrice est de l'aluminium.

3. Procédé selon la revendication 1, caractérisé en ce que l'impureté donatrice est choisie dans le groupe comprenant l'indium, l'oxyde d'indium.

4. Procédé selon l'une quelconque des revendications 1 à 3, caractérisé en ce que l'impureté acceptrice est du lithium.

5. Procédé selon l'une quelconque des revendications 1 à 3, caractérisé en ce que l'impureté acceptrice est choisie dans le groupe comprenant le potassium et le sodium.

6. Procédé selon l'une quelconque des revendications 1 à 5, caractérisé en ce qu'on dépose sur la surface supérieure de ladite plaquette (1) une couche (2) du corps constituant ou donnant l'impureté donatrice, cette couche servant en même temps d'électrode supérieure.

7. Procédé selon la revendication 6, caractérisé en ce qu'on dépose sur la couche (2) du corps constituant ou donnant l'impureté donatrice une couche (3) d'un corps contenant l'impureté acceptrice.

8. Procédé selon l'une quelconque des revendications 1 à 7, caractérisé en ce que ladite double diffusion est réalisée en milieu oxydant.

9. Procédé selon la revendication 8, caractérisé en ce que le corps donnant l'impureté acceptrice est un sel ou une base à propriétés oxydantes d'un métal choisi dans le groupe comprenant le lithium, le potassium et le sodium.

10. Procédé selon la revendication 8, caractérisé en ce que le milieu oxydant est contenu dans l'environnement de la plaquette (1) lorsque celle-ci est soumise à la double diffusion.

11. Procédé de réalisation d'un composant semiconducteur présentant des propriétés électroluminescentes et photodétectrices, caractérisé en ce qu'il comporte les étapes suivantes :
   a) on part d'une plaquette (1) en matériau semiconducteur ZnTe de type P,
   b) on dépose sur la face supérieure de ladite plaquette (1) une couche (2) d'aluminium,
   c) on dépose sur la face supérieure de la couche (2) d'aluminium une couche (3) de LiNO₃,
   d) on chauffe l'ensemble de telle façon qu'on obtienne une double diffusion simultanée de l'aluminium et du lithium, résultant en la création d'une zone de piégeage de trous $(x_i)$ et d'une zone compensée à résistivité élevée $(x_j)$ et
   e) on dépose sur la face inférieure de la plaquette (1) une deuxième électrode (6).

12. Procédé selon la revendication 11, caractérisé en ce que entre les étapes b) et c), on grave la couche d'aluminium.

13. Procédé selon la revendication 11, caractérisé en ce que entre les étapes c) et d), on grave les couches d'aluminium et de LiNO₃.

14. Procédé de réalisation d'un composant semiconducteur présentant des propriétés électroluminescentes et photodétectrices, caractérisé en ce qu'il comporte les étapes suivantes :
   a) on réalise un alliage aluminium-lithium,
   b) on dépose sur la face supérieure d'une plaquette (1) en matériau semiconducteur ZnTe de type P une couche (4) dudit alliage,
   c) on chauffe l'ensemble de telle façon qu'on obtienne une double diffusion simultanée de l'aluminium et du lithium résultant en la création d'une zone de piégeage de trous $(x_i)$ et d'une zone compensée à résistivité élevée $(x_j)$ et
   d) on dépose sur la face inférieure de la plaquette (1) une deuxième électrode (6).

## Claims

1. Process for the production of a semiconducting component possessing opto-electronic conversion properties, in accordance with which the top surface of a wafer (1) of P-type ZnTe semiconducting material is subjected to a first diffusion of a donor impurity, creating a compensated zone of high resistivity $(x_j)$, to a second, surface diffusion $(x_i)$ of an acceptor impurity and to the deposition of metal contacts on both faces, characterised in that the combinations of the two diffusions carried out simultaneously creates a hole-trapping zone.

2. Process according to Claim 1, characterised in that the donor impurity is aluminium.

3. Process according to Claim 1, characterised in that the donor impurity is chosen from the group comprising indium and indium oxide.

4. Process according to any one of Claims 1 to 3, characterised in that the acceptor impurity is lithium.

5. Process according to any one of Claims 1 to 3, characterised in that the acceptor impurity is chosen from the group comprising potassium and sodium.

6. Process according to any one of Claims 1 to 5, characterised in that a layer (2) of the substance forming or giving the donor impurity is deposited on the top surface of the said wafer (1), this layer serving at the same time as a top electrode.

7. Process according to Claim 6, characterised in that a layer (3) of a substance containing the acceptor impurity is deposited on the layer (2) of the substance forming or giving the donor impurity.

8. Process according to any one of Claims 1 to 7, characterised in that the said double diffusion is carried out in a oxidizing medium.

9. Process according to Claim 8, characterised in that the substance giving the acceptor impurity is a salt or a base, with oxidizing properties, of a metal chosen from the group comprising lithium, potassium and sodium.

10. Process according to Claim 8, characterised in that the oxidizing medium is contained in the environment of the wafer (1) when the latter is subjected to double diffusion.

11. Process for the production of a semiconducting component possessing electroluminescent and photodetecting properties, characterised in that it comprises the following steps :

a) a wafer (1) of P-type ZnTe semiconducting material is initially taken,

b) a layer (2) of aluminium is deposited on the top face of the said wafer (1),

c) a layer (3) of $LiNO_3$ is deposited on the top face of the layer (2) of aluminium,

d) the whole is heated so as to obtain a simultaneous double diffusion of the aluminium and the lithium, resulting in the creation of a hole-trapping zone $(x_i)$ and a compensated zone of high resistivity $(x_j)$, and

e) a second electrode (6) is deposited on the bottom face of the wafer (1).

12. Process according to Claim 11, characterised in that the layer of aluminium is etched between steps b) and c).

13. Process according to Claim 11, characterised in that the layers of aluminium and of $LiNO_3$ are etched between steps c) and d).

14. Process for the production of a semiconducting component possessing electroluminescent and photodetecting properties, characterised in that it comprises the following steps :

a) an aluminium-lithium alloy is produced,

b) a layer (4) of the said alloy is deposited on the top face of a wafer (1) of P-type ZnTe semiconducting material,

c) the whole is heated so as to obtain a simultaneous double diffusion of the aluminium and the lithium, resulting in the creation of a hole-trapping zone $(x_i)$ and a compensated zone of high resistivity $(x_j)$, and

d) a second electrode (6) is deposited on the bottom face of the wafer (1).

**Ansprüche**

1. Verfahren zum Herstellen von die Eigenschaften eines opto-elektronischen Wandlers aufweisenden Halbleiter-Bauelementen, bei welchem die Oberseite eines Plättchens (1) aus Halbleitermaterial ZnTe des Typs P einer ersten Diffusion einer Donator-Verunreinigung zur Bildung einer kompensierten Zone mit erhöhtem spezifischem Leitungswiderstand $(x_j)$, einer zweiten oberflächlichen Diffusion $(x_i)$ einer Akzeptor-Verunreinigung und dem Auftrag von metallischen Kontakten auf den beiden Seiten unterworfen wird, dadurch gekennzeichnet, daß die Kombination der beiden gleichzeitig ausgeführten Diffusionen eine Lochfangzone schafft.

2. Verfahren nach Anspruch 1, dadurch gekennzeichnet, daß die Donator-Verunreinigung Aluminium ist.

3. Verfahren nach Anspruch 1, dadurch gekennzeichnet, daß die Donator-Verunreinigung aus der Indium und Indiumoxid umfassenden Gruppe gewählt ist.

4. Verfahren nach wenigstens einem der Ansprüche 1 bis 3, dadurch gekennzeichnet, daß die Akzeptor-Verunreinigung Lithium ist.

5. Verfahren nach wenigstens einem der Ansprüche 1 bis 3, dadurch gekennzeichnet, daß die Akzeptor-Verunreinigung aus der Kalium und Natrium umfassenden Gruppe gewählt ist.

6. Verfahren nach wenigstens einem der Ansprüche 1 bis 5, dadurch gekennzeichnet, daß man auf der Oberseite des Plättchens (1) eine Schicht (2) aus einem die Donator-Verunreinigung darstellenden oder sie abgebenden Material deponiert, welche gleichzeitig als die obere Elektrode dient.

7. Verfahren nach Anspruch 6, dadurch gekennzeichnet, daß man auf der Schicht (2) aus dem die Donator-Verunreinigung darstellenden oder sie abgebenden Material eine Schicht (3) aus einem die Akzeptor-Verunreinigung enthaltenden Material deponiert.

8. Verfahren nach wenigstens einem der Ansprüche 1 bis 7, dadurch gekennzeichnet, daß die doppelte Diffusion in einem oxydierenden Milieu ausgeführt wird.

9. Verfahren nach Anspruch 8, dadurch gekennzeichnet, daß das die Akzeptor-Verunreinigung abgebende Material ein Salz oder eine oxydierende Eigenschaften aufweisende Base eines aus der Lithium, Kalium und Natrium umfassenden Gruppe gewählten Metalls ist.

10. Verfahren nach Anspruch 8, dadurch gekennzeichnet, daß das oxydierende Milieu in der Umgebung des Plättchens (1) vorhanden ist, während dieses der doppelten Diffusion unterworfen wird.

11. Verfahren zum Herstellen eines elektroluminiszente und lichtempfindliche Eigenschaften aufweisenden Halbleiter-Bauelements, dadurch gekennzeichnet,

a) daß man von einem Plättchen (1) aus Halbleitermaterial ZnTe des Typs P ausgeht,

b) daß man auf der Oberseite des Plättchens (1) eine Schicht (2) aus Aluminium deponiert,

c) daß man auf der Oberseite des Aluminiumschicht (2) eine Schicht (3) aus $LiNO_3$ deponiert,

d) daß man dieses Gebilde derart erwärmt, daß man eine gleichzeitige, doppelte Diffusion des Aluminiums und des Lithiums erhält, wodurch eine Lochfangzone und eine kompensierte Zone von erhöhtem spezifischem Leitungswiderstand $(x_j)$ entstehen, und

e) daß man auf der Unterseite des Plättchens (1) eine zweite Elektrode (6) deponiert.

12. Verfahren nach Anspruch 11, dadurch gekennzeichnet, daß man die Aluminiumschicht zwischen den Schritten b) und c) ätzt.

13. Verfahren nach Anspruch 11, dadurch gekennzeichnet, daß man zwischen den Schritten c) und d) die Schichten aus Aluminium und LiNO$_3$ ätzt.

14. Verfahren zum Herstellen eines elektroluminiszente und lichtempfindliche Eigenschaften aufweisenden Halbleiter-Bauelements, dadurch gekennzeichnet,

a) daß man eine Aluminium-Lithiumlegierung herstellt,

b) man eine Schicht (4) dieser Legierung auf der Oberseite eines Plättchens aus Halbleitermaterial ZnTe des Typs P deponiert,

c) daß man dieses Gebilde derart erwärmt, daß man eine gleichzeitige, doppelte Diffusion des Aluminiums und des Lithiums erhält, wodurch eine Lochfangzone und eine kompensierte Zone von erhöhtem spezifischem Leitungswiderstand ($x_j$) entstehen, und

d) daß man auf der Unterseite des Plättchens (1) eine zweite Elektrode (6) deponiert.

FIG. 1

FIG. 2$_a$

FIG. 2_b

FIG. 3